# EUROPEAN PATENT APPLICATION

(11) **EP 3 333 681 A1**
(43) Date of publication of application: **13.06.2018**
(21) Application number: 15900049.6
(22) Date of filing: 05.08.2015
(51) Int. Cl.: G06F 3/041

(54) **TOUCH FILM, ORGANIC LIGHT-EMITTING DIODE DISPLAY PANEL AND PREPARATION METHOD OF TOUCH FILM**

(71) Applicant: Shenzhen Royole Technologies Co., Ltd., Shenzhen, Guangdong 518172 (CN)
(72) Inventor: ZHANG, Jiaqi, Shenzhen Guangdong 518052 (CN); DAI, Tianming, Shenzhen Guangdong 518052 (CN); XU, Wenqing, Shenzhen Guangdong 518052 (CN)
(74) Representative: Hamer, Christopher K.
(86) International application number: PCT/CN2015/086115
(87) International publication number: WO 2017/020274

(57) **Abstract**

A touch film includes a plastic film layer, a touch sensing layer, a linear polarizing film layer, a phase retardation film layer and a barrier layer that are successively laminated. An upper surface of the plastic film layer away from the touch sensing layer has a flexible protective coating. The touch film of the present disclosure is flexible and can adaptively change the surface shape of the product so that the touch film has a wider range of applications. The disclosure further provides an OLED display panel and a method for preparing a touch film.

## Description

### TECHNICAL FIELD

The present disclosure relates to the field of touch display, and more particularly to a touch film, a method for preparing a touch film, and an organic light-emitting diode (OLED) display panel.

### BACKGROUND

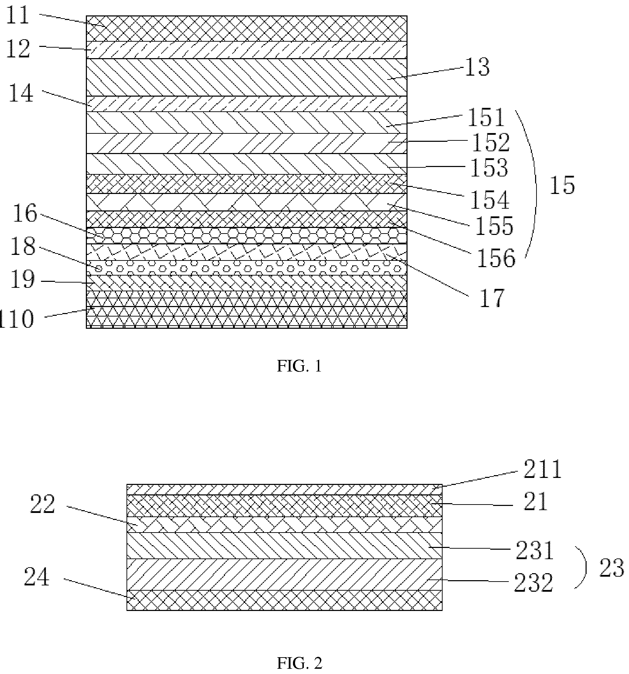

FIG. 1 is a schematic cross-sectional structure view of a common touch organic light-emitting diode (OLED) display panel, which includes a cover glass 11, a first optical clear adhesive layer 12, a touch panel 13, a second optical clear adhesive layer 14, a circular polarizer layer 15, a plastic thin-film layer 16, a barrier layer 17, an adhesive layer 18, an encapsulation layer 19, and an OLED panel layer 110 that are successively laminated from top to bottom. The circular polarizer layer 15 further includes a first protective film layer (TAC) 151, a linear polarizing film layer 152, a second protective film layer (TAC) 153, a first pressure sensitive adhesive layer (PSA) 154, a phase retardation film layer 155, and a second pressure sensitive adhesive layer (PSA) 156 that are successively laminated from top to bottom. The cover glass 11 in the conventional product structure is made of a hard material and the OLED display panel is not flexible and the application thereof is limited. The thickness of the cover glass 11, the multi-film layer design of the touch panel 13, and the multi-film layer design of the circular polarizer layer 15 increase the overall thickness of the OLED display panel, resulting in a large radius of curvature of the product, which is not conducive to the bending of the product.

Therefore, it is desirable to provide a touch film and an OLED display panel having flexible features and a small thickness.

### SUMMARY

A touch film, an OLED display panel, and a method for preparing a touch film are provided in embodiments of the present disclosure, through which flexibility requirements of a product can be met and the thickness of the product can be reduced.

According to one aspect of the present disclosure, there is provided a touch film, which includes a plastic film layer, a touch sensing layer, a linear polarizing film layer, a phase retardation film layer, and a barrier layer successively laminated. The plastic film layer is provided with a flexible protective coating on an upper surface of the plastic film layer that is away from the touch sensing layer.

According to another aspect of the present disclosure, there is provided a method for preparing a touch film. The method includes the following operations.

A plastic film layer, a touch sensing layer, and a protective coating are prepared, the touch sensing layer is located on a lower surface of the plastic film layer prepared and the protective coating is located on an upper surface of the plastic film layer prepared, so as to form a first film group.

A linear polarizing film layer is prepared to form a second film group.

A phase retardation film layer and a barrier layer are prepared, and the barrier layer is provided on a lower surface of the phase retardation film layer, so as to form a third film group.

The first film group, the second film group, and the third film group are laminated, so as to form the touch film through a bonding process.

According to yet another aspect of the present disclosure, there is further provided an OLED display panel, which includes an OLED panel and the touch film according to one of the above-described aspects. The touch film is disposed at a light-emitting side of the OLED panel.

Compared with the related art, with aid of the protective coating in the touch film provided by the present disclosure, the touch film can be flexible and therefore, a surface shape of a product can be changed adaptively. For example, a curved surface can be formed on the outer surface, so that the touch film can be widely used. Further, the thickness of the touch sensing layer and the circular polarizing film layer is reduced, and the cover glass, a plurality of optical clear adhesive layers, and the plastic thin-film layer are omitted, as such, the overall thickness of the touch film is reduced greatly and resulting in a reduced radius of curvature, therefore, the touch film is easy to bend. Omission of multiple film layers can simplify the production procedure and process of the touch film and save cost. The method for preparing a touch film provided in the disclosure has a simplified process and high production efficiency, which can in turn greatly save production cost of the touch film. The OLED display panel provided herein is capable of being used to achieve full flexibility.

### BRIEF DESCRIPTION OF THE DRAWINGS

In order to better illustrate embodiments of the disclosure or technical solutions of the related art, the drawings to be used will be briefly described below. It will be apparent that the drawings described in the following are merely embodiments of the disclosure, and for those of ordinary skill in the art, other drawings may be without creative work.
FIG. 1 is a schematic cross-sectional view illustrating a conventional touch OLED display panel.
FIG. 2 is a schematic cross-sectional view illustrating a touch film according to the present disclosure.
FIG. 3 is schematic flowchart illustrating a method for preparing a touch film according to the present disclosure.
FIG. 4 is a schematic cross-sectional view illustrating an OLED display panel according to the present disclosure.

### DETAILED DESCRIPTION OF ILLUSTRATED EMBODIMENTS

In order to better illustrate the technical solutions of the embodiments of the disclosure or of the related art, the accompanying drawings for use with description of the embodiments are briefly described below. It will be apparent that the drawings described in the following represent merely some embodiments of the disclosure, and that those of ordinary skill in the art will be able to obtain other drawings from these drawings without performing any creative work.

According to embodiments of the present disclosure, there is provided a touch film. As illustrated in FIG.2, the touch film includes a protective coating 211, a plastic film layer 21, a touch sensing layer 22, a circular polarizing film layer 23, and a barrier layer 24 successively laminated from top to bottom. An upper surface of the plastic film layer 21 away from the circular polarizing film layer 23 is subjected to a coating surface hardening treatment to form the protective coating 211. The protective coating 211 has an anti-scratch performance while retaining the flexibility of the film, therefore, it can serve as a cover plate of the touch film for preventing the surface of the touch film from being scratched during assembly or use. The touch sensing layer 22 can be prepared and formed on the lower surface of the plastic film layer 21 adjacent to the circular polarizing film layer 23 in a silk-screen printing or laser manner, compared with the touch panel of the related art, the protective film layer is not required and the thickness of the product can be reduced. The circular polarizing film layer 23 includes a linear polarizing film layer 231 and a phase retardation film layer 232, compared with the circular polarizer layer of the related art, a plurality of film layers and a plurality of adhesive layers are omitted, which can save cost and reduce the thickness of the circular polarizing film layer 23.

It is to be understood that the protective coating 211 in this embodiment can make the touch film flexible and therefore, the surface shape of the product can be adaptively changed. For example, a curved surface can be formed on the outer surface, making the touch film widely used. The cover glass of the related art is made of a hard material and has a larger thickness, and thus is not conducive to the preparation of flexible products. In the touch film of the present disclosure, the thickness of the touch sensing layer 22 and the circular polarizing film layer 23 is reduced, and the cover glass, the plurality of optical clear adhesive layers, and the plastic thin-film layer are omitted, as such, the overall thickness of the touch film is reduced a lot, resulting in a reduced radius of curvature, as such, the product is easy to bend. The omission of the plurality of film layers simplifies the production procedure and process of the touch film and saves cost.

Further, the linear polarizing film layer 231 is formed by performing dyeing, stretching, color compensation or other preparation technologies on a polyvinyl alcohol (PVA) thin film. The liner polarizing film layer 231 has a linear polarization function.

Further, the phase retardation film layer 232 is a cyclic olefin polymer (COP) thin film to achieve \ /4 phase retardation for light formation.

Further, the barrier layer 24 is formed on the lower surface of the phase retardation film layer 232 away from the linear polarizing film layer 231 via a chemical vapor deposition (CVD) process, an atomic layer deposition (ALD) process, or a physical vapor deposition (PVD) process. The barrier layer 24 may be defined by an inorganic film or by stacking of multi-layer inorganic film layers and multi-layer organic film layers. The barrier layer 24 has waterproof and anti-oxygen performance, and protects the circular polarizing film layer 23.

Further, a second barrier layer may be deposited between the plastic film layer 21 and the touch sensing layer 22 to better achieve the purpose of waterproof, anti-oxygen, and protection of the circular polarizing film layer 23.

Further, a surface of the touch sensing layer 22 in contact with the linear polarizing film layer 231 may be a rough film surface. Additionally or alternatively, a surface of the phase retardation film layer 232 in contact with the linear polarizing film layer 231 may be a rough film surface. In this way, the linear polarizing film layer 231 can be fixed.

According to embodiments of the present disclosure, there is provided a method for preparing a touch film. The method can be achieved through a production line A, a production line B, a production line C, and an assembly line D. The preparing procedure is as follows.

The production line A is configured for preparing a first film group and includes the following operations:

At step A1, a substrate is provided from a plastic thin-film coil to form a plastic film layer 21.

At step A2, a touch sensor pattern and conductive silver paste are printed on a lower surface of the plastic film layer 21 to form a touch sensing layer 22. Compared with the production of a complete touch panel in the related art, protective layer materials of a touch sensor can be saved and assembling process can be simplified, thus improving production efficiency, saving cost, and reducing the thickness of the touch film.

At step A3, an upper surface of the plastic film layer 21 is subjected to a coating hardening treatment to form a protective coating 211. The protective coating 211 has abrasion resistance (anti-scratch) while retaining the flexibility of the film, and can function as a cover plate of the touch film for preventing the surface of the touch film from being scratched during assembly or use of the touch film. Thus, the cover glass used in the related art is not required, and the touch film has a flexible feature and can be widely used.

At step A4, the protective coating 211, the plastic film layer 21, and the touch sensing layer 22 can be dried to form the first film group.

It is to be understood that in the production line A, step A1, step A2, step A3, and step A4 can be conducted sequentially, or step A1, step A3, step A2, and step A4 can be conducted sequentially.

The production line B is configured for preparing a second film group and may include the following operations:

At step B1, a substrate may be provided from a polyvinyl alcohol thin film coil.

At step B2, dyeing, stretching, and color compensation are performed on the substrate obtained at step B1 to form a linear polarizing film layer 231. The linear polarizing film layer 231 then proceeds to the touch film assembly line to be assembled. Upper and lower protective film layers (such as triacetyl cellulose, (TAC)) are no longer required to protect the linear polarizing film layer 231 during production, thus saving the material of the protective film layer and simplifying the assembling process, improving production efficiency, saving cost, and reducing the thickness of the touch film.

The second film group is formed.

The production line C is configured for preparing a third film group and includes the following operations:

At step C1, a substrate is provided from a cyclic olefin polymer thin film coil to form a phase retardation film layer 232. The phase retardation film layer 232 then proceeds to the touch film assembly line to be assembled. Upper and lower pressure sensitive adhesive (PSA) layers for pasting the phase retardation film layer 232 are no longer required during production, thus saving the material of the film layer, simplifying the assembling process, improving production efficiency, saving cost, and reducing the thickness of the touch film.

At step C2, a barrier layer 24 is formed on a lower surface of the phase retardation film layer 232 in chemical vapor deposition (CVD), atomic layer deposition (ALD), or physical vapor deposition (PVD) to form the third film group.

Assembly line D is configured for assembling the touch film and includes the following operations:

At step D1, the first film group, the second film group, and the third film group prepared through the production lines A, B, and C are laminated to form the touch film through a bonding process. After the bonding process, the touch film may include the protective coating 211, the plastic film layer 21, the touch sensing layer 22, the linear polarizing film layer 231, the phase retardation film layer 232, and the barrier layer 24 successively laminated from top to bottom.

At step D2, the touch film formed at step D1 is roll-packaged.

As can be seen, the production line A, production line B, and production line C mentioned above are simultaneously conducted and film groups prepared therefrom simultaneously proceed to assembly line D to be assembled, thus simplifying the process, improving the production efficiency, and saving the cost of production of the touch film.

Further, after forming the touch film through a roll-to-roll bonding process, a release layer may be formed on one side of the barrier layer 24 of the touch film away from the phase retardation film layer 232. The release layer can be used as a protective film prior to usage of the touch film. As one implementation, the release layer may be disposed on the barrier layer 24 of the touch film by means of vacuum adsorption.

It is to be understood that the method for preparing a touch film provided herein can reduce the overall thickness of the touch film, reduce the radius of curvature of the touch film, which make the touch film easy to bend and can be applied to flexible products. The production process of the touch film can be simplified, the production efficiency can be improved, and production cost can be saved.

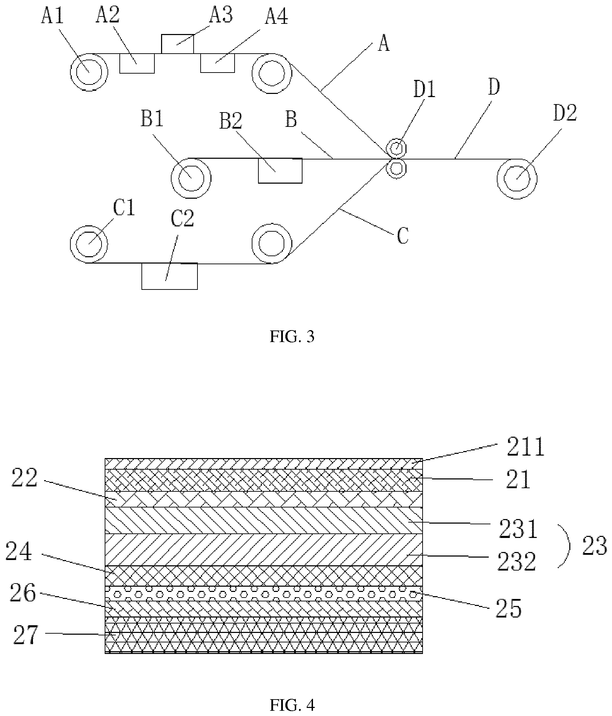

According to embodiments of the present disclosure, there is provided an OLED display panel. As illustrated in FIG. 4, the OLED display panel includes an OLED panel and the touch film described in the above embodiments. The touch film is disposed at a light-emitting side of the OLED panel.

Further, when using a top emitting OLED panel, an encapsulation layer 26 can be formed at the light-emitting side of the OLED panel 27 through an encapsulation process. One side of the encapsulation layer 26 away from the OLED panel 27 is adhered to one side of the barrier layer 24 away from the phase retardation film layer 232 via an adhesive layer 25. The touch film provided in the embodiments of the disclosure has advantages of flexible design and small thickness, which can be beneficial to full flexible applications of the OLED display panel. The touch film can also have high production efficiency and low cost.

The touch film, the OLED display panel, and the method for preparing a touch film provided in embodiments of the present disclosure have been described above in detail. Principles and implementations of the present disclosure have been described with embodiments provided herein to help understand the method of the disclosure and principles thereof. It will be apparent to those of ordinary skill in the art that changes may be made to the implementations and applications thereof in accordance with the inventive ideas of the present disclosure. Therefore, the contents of this specification should not be construed as limiting the disclosure.

## Claims

1. A touch film, comprising:
a plastic film layer (21), a touch sensing layer (22), a linear polarizing film layer (231), a phase retardation film layer (232), and a barrier layer (24) successively laminated, wherein the plastic film layer (21) is provided with a flexible protective coating on an upper surface of the plastic film layer (21) that is away from the touch sensing layer.

2. The touch film of claim 1, wherein the barrier layer (24) is defined by at least one inorganic film or a combination of at least one inorganic film and at least one organic film.

3. The touch film of claim 1, wherein a second barrier layer is sandwiched between the plastic film layer (21) and the touch sensing layer (22).

4. The touch film of claim 1, wherein a surface of the touch sensing layer (22) in contact with the linear polarizing film layer (231) is a rough film surface and/or a surface of the phase retardation film layer (232) in contact with the linear polarizing film layer is a rough film surface.

5. The touch film of claim 1, wherein the phase retardation film layer (232) is a cyclic olefin polymer thin film.

6. A method for preparing a touch film, comprising:
preparing a plastic film layer, a touch sensing layer, and a protective coating, the touch sensing layer being located on a lower surface of the plastic film layer prepared, and the protective coating being located on an upper surface of the plastic film layer prepared, so as to form a first film group;
preparing a linear polarizing film layer to form a second film group;
preparing a phase retardation film layer and a barrier layer, the barrier layer being located on a lower surface of the phase retardation film layer to form a third film group; and
laminating the first film group, the second film group, and the third film group to form the touch film via a bonding process.

7. The method of claim 6, wherein the preparing of the first film group, the second film group, and the third film group are carried out simultaneously.

8. The method of claim 6, wherein the upper surface of the plastic film layer is subjected to a coating surface hardening treatment to form the protective coating.

9. The method of claim 6, wherein a touch sensor pattern and a conductive silver paste are printed on the lower surface of the plastic film layer to form the touch sensing layer.

10. The method of claim 6, wherein a polyvinyl alcohol thin film is subjected to dyeing, stretching, and color compensation to form the linear polarizing film layer.

11. The method of claim 6, wherein the barrier layer is formed on the lower surface of the phase retardation film layer through chemical vapor deposition (CVD), atomic layer deposition (ALD), or physical vapor deposition (PVD).

12. An organic light-emitting diode (OLED) display panel, comprising:
an OLED panel and the touch film in accordance with any of claims 1 to 5, wherein the touch film is provided at a light-emitting side of the OLED panel.
